# EUROPEAN PATENT APPLICATION

(11) **EP 2 241 651 A1**
(43) Date of publication of application: **20.10.2010**
(21) Application number: 08869403.9
(22) Date of filing: 19.12.2008
(51) Int. Cl.: C23C 16/455, H01L 21/205, H05H 1/46

(54) **PLASMA PROCESSING APPARATUS**

(30) Priority: 11.01.2008 JP 2008004600
(71) Applicant: Sharp Kabushiki Kaisha, Osaka-shi, Osaka 545-8522 (JP)
(72) Inventor: KISHIMOTO, Katsushi, Osaka-shi, Osaka, 545-8522 (JP); FUKUOKA, Yusuke, Osaka-shi, Osaka, 545-8522 (JP)
(74) Representative: Müller - Hoffmann & Partner
(86) International application number: PCT/JP2008/073227
(87) International publication number: WO 2009/087887

(57) **Abstract**

The invention provides a plasma processing apparatus that can uniformly supply a gas between a cathode electrode and an anode electrode, even when areas of both electrodes are increased, and that can reduce thicknesses of both electrodes.

Two sets of an anode electrode 4 and a cathode electrode 12 are arranged in a chamber 15 of a plasma processing apparatus 100 so as to be opposite to each other. The cathode electrode 12 has a shower plate 2, a back plate 3, and a hollow room 17. The shower plate 2 is provided with first gas-ejection holes 18 for ejecting a gas, which is introduced into the hollow room 17, to a portion between both electrodes 4 and 12. A gas introducing port 31 for introducing a gas from an outside is provided at an electrode end face at a lower face (a inner-wall 19 of the hollow room 17 opposite to the shower plate 2) of the back plate 3. The inner-wall 19 of the hollow room 17 is provided with second gas-ejection holes 32 for ejecting the gas to the hollow room 17, and a gas guiding section 33 for guiding the gas to the second gas-ejection holes 32 from the gas introducing port 31.

## Description

### TECHNICAL FIELD

The present invention relates to a plasma processing apparatus, and more particularly to a plasma processing apparatus having a feature in a gas supplying structure used for generating a plasma.

### BACKGROUND ART

A plasma processing apparatus generally has a pair of a cathode electrode and an anode electrode, and further includes a device that applies high-frequency power to either the cathode electrode or the anode electrode, and a gas supplying device that supplies a reactive gas for generating a plasma. In such a plasma processing apparatus, high-frequency power is applied while supplying the reactive gas between the cathode electrode and the anode electrode, whereby a subject to be processed placed between the cathode electrode and the anode electrode is plasma-processed.

The reactive gas is generally supplied between the cathode electrode and the anode electrode, i.e., a plasma generating space, by using a so-called shower plate provided with gas-ejection holes on a surface of the cathode electrode that is opposite to the anode electrode. In order to supply the reactive gas by using the shower plate in such a manner that the gas is uniformly diffused over the whole plasma generating space, it is necessary to fully diffuse the gas in a hollow portion at an upstream side of the shower plate, and therefore, a capacity of the hollow portion has to be increased.

In order to supply the reactive gas so as to uniformly diffuse the gas, Patent Document 1 discloses a structure including such a shower plate. The shower plate comprises plural hollow rooms disposed in plural stages, each of which spreads in a plane, plural through-holes that extend through the respective hollow rooms, a gas introducing port that introduces a processing gas into the hollow room in a first stage, plural gas-ejection holes that ejects the introduced processing gas from the hollow room in a final stage, and plural communication holes that are formed on a wall, which separates the adjacent hollow rooms, for allowing the processing gas to flow into an upstream hollow room to a downstream hollow room, wherein the gas-ejection holes and the communication holes are provided around the plural through-holes.

It is understood that, with such a structure, the processing gas introduced into the hollow room in the first stage is guided to the hollow room in a next stage through the communication holes, and then, the processing gas is ejected into a chamber from the gas-ejection holes, resulting in that an amount of the gas ejected from the respective communication holes of respective stages and the respective gas-ejection holes of the respective rooms is made uniform, and the processing gas can be supplied uniformly to the subject to be processed in the chamber.
Patent Document 1: Japanese Unexamined Patent Publication No. 2006-322050

### DISCLOSURE OF THE INVENTION

### PROBLEMS THAT THE INVENTION IS TO SOLVE

However, when large-sized cathode electrode and anode electrode corresponding to a large substrate are used, the gas is not sufficiently diffused in the hollow room by the shower plate having the structure disclosed in Patent Document 1, whereby there arises a problem that uniformity of the processing gas supplied to the subject to be processed in the chamber is not satisfactory.

In particular, in a plasma processing apparatus having plural sets of a cathode electrode and an anode electrode in opposing directions thereof, it is necessary to decrease a thickness of the cathode electrode and the anode electrode in an arranging direction in order to downsize the apparatus, but a volume of the hollow room in the cathode electrode cannot be increased, and hence, the above-mentioned problem becomes more remarkable.

The present invention is accomplished in view of the above-mentioned circumstances, and aims to provide a plasma processing apparatus that can uniformly supply a gas between a cathode electrode and an anode electrode even when areas of the cathode electrode and the anode electrode are increased, and that can decrease the thickness of the cathode electrode and the anode electrode.

### MEANS OF SOLVING THE PROBLEMS

According to the present invention, there is provided a plasma processing apparatus comprising: a reaction chamber for a plasma reaction; an exhaust section for exhausting a gas from the reaction chamber; and a flat-plate-like cathode electrode and a flat-plate-like anode electrode arranged in the reaction chamber so as to be opposite to each other, wherein plural sets of the cathode electrode and the anode electrode are arranged in opposing directions thereof, each of the cathode electrodes includes a hollow room therein, and a shower plate provided with plural first gas-ejection holes for ejecting the gas, which is introduced into the hollow room, from the hollow room to a portion between the cathode electrode and the anode electrode, a gas introducing port for introducing the gas from an outside of the cathode electrode is provided at an electrode end face of an inner-wall of the hollow room opposite to the shower plate at the cathode electrode, and plural second gas-ejection holes for ejecting the gas into the hollow room and a gas guiding section for guiding the gas from the gas introducing port to the second gas-ejection holes are provided at the inner-wall of the hollow room opposite to the shower plate.

### EFFECTS OF THE INVENTION

In the plasma processing apparatus according to the present invention, plural second gas-ejection holes for ejecting the gas into the hollow room are provided on the surface of the inner-wall of the hollow room of the cathode electrode opposite to the shower plate, and the gas guiding section for guiding the gas from the gas introducing port, which is provided to introduce the gas from an outside of the cathode electrode, to the second gas-ejection holes is provided at the inner-wall of the hollow room opposite to the shower plate. Accordingly, even when areas of the cathode electrode and the anode electrode are increased, the gas can be supplied uniformly between the cathode electrode and the anode electrode from a first gas-ejection hole of the cathode electrode, and further, thicknesses of the cathode electrode and the anode electrode can be reduced.

### BRIEF DESCRIPTION OF THE DRAWINGS

Fig. 1 is an explanatory view showing an overall structure of a plasma processing apparatus (thin-film forming apparatus) according to one embodiment of the present invention.
Fig. 2 is a bottom view of a cathode electrode constituting the plasma processing apparatus in Fig. 1.
Fig. 3 is a sectional view taken along line A1 - A1 in Fig. 2.
Fig. 4 is a sectional view taken along line A2 - A2 in Fig. 2.

### EXPLANATION OF THE REFERENCE NUMERALS

- 1: Substrate
- 2: Shower plate
- 3: Back plate
- 4: Anode electrode
- 5: Second support member
- 6: First support member
- 7: Tray
- 10: Plasma exciting power source
- 11: Impedance matching box
- 12: Cathode electrode
- 15: Chamber (reaction chamber)
- 17: Hollow room
- 18: First gas-ejection hole
- 19: Inner-wall of the hollow room
- 20: Exhaust pipe
- 21: Vacuum pump
- 22: Pressure controller
- 24: Heater
- 27: Power introducing terminal
- 28: Gas introducing section
- 29: Exhaust section
- 30: High-frequency power source section
- 31: Gas introducing port
- 32: Second gas-ejection hole
- 33: Gas guiding section
- 33a: Channel
- 33b: Cover

### BEST EMBODIMENTS FOR CARRYING OUT THE INVENTION

A plasma processing apparatus according to the present invention is used for forming a silicon thin film with a plasma CVD method, for example.

Examples of the silicon thin film include a thin film from a crystalline thin film to an amorphous thin film having a silicon as a main component. A gas containing a silicon element can be used as a reactive gas. Specifically, a silane (SiH₄), or disilane (Si₂H₆) can be used as the reactive gas, wherein these silane and disilane may be diluted with a hydrogen (H₂), helium (He), or the like.

Other examples of the silicon thin film formed by the plasma processing apparatus according to the present invention include a silicon carbide (SiC) film, a silicon nitride (SiN) film, a silicon oxide (SiO) film, an SiGe film, and the like.

When a silicon carbide film is formed, a CH₄ gas or C₂H₆ gas containing a carbon element is simultaneously introduced as a reactive gas in addition to a gas containing a silicon element. When a silicon nitride film is formed, an NH₃ gas or NO gas containing a nitrogen element is simultaneously introduced as a reactive gas in addition to the gas containing a silicon element. When a silicon oxide film is formed, an NO gas or CO₂ gas containing an oxygen element is simultaneously introduced as a reactive gas in addition to the gas containing a silicon element. When a SiGe film is formed, a GeH₄ gas containing a germanium element is simultaneously introduced as a reactive gas in addition to the gas containing a silicon element.

An impurity may be added to the silicon thin film in order to control conductivity. When the silicon thin film is made into an n-type, a PH₃ gas containing an impurity element is simultaneously introduced, while when the silicon film is made into a p-type, a B₂H₆ gas containing an impurity element is simultaneously introduced.

In the plasma processing apparatus according to the present invention, a chamber in which at least an interior can be evacuated can be used as the reaction chamber. Such a reaction chamber can be produced with, for example, stainless steel, an aluminum alloy, or the like. When the reaction chamber is made of two or more members, it is preferable that the chamber has a structure that can completely be sealed by using an O-ring at a fitting portion.

In the plasma processing apparatus according to the present invention, examples of usable exhaust section include an exhaust section including a vacuum pump, an exhaust pipe that connects the reaction chamber and the vacuum pump, and a pressure controller provided midway on the exhaust pipe.

In the plasma processing apparatus according to the present invention, a high-frequency power source section for applying high-frequency power between the cathode electrode and the anode electrode is provided. As the high-frequency power source section, for example, one composed of a plasma exciting power source and an impedance matching box can be used.

In the plasma processing apparatus according to the present invention, one having a flat plate shape and made of a heat-resistant conductive material such as stainless steel, an aluminum alloy, carbon, or the like can be used as the cathode electrode and the anode electrode. A shape, size, and material of the cathode electrode and the anode electrode are preferably substantially equal, and when a residual processing strain is left due to a machining process, the residual processing strain is preferably removed by an annealing treatment.

The used cathode electrode is provided with a hollow room provided therein, and a shower plate provided with plural first gas-ejection holes for ejecting a gas, which is introduced into the hollow room, from the hollow room to a portion between the cathode electrode and the anode electrode. According to need, an electrode-heating heater may be provided in the hollow room. The anode electrode has a hollow structure, for example, and an electrode-heating heater may be incorporated therein.

In the plasma processing apparatus according to the present invention, a gas introducing port is provided at an end face of the cathode electrode of an inner-wall of the hollow room opposite to the shower plate. The gas introducing port is for introducing a gas into the hollow room from an outside of the cathode electrode.

Plural second gas-ejection holes and a gas guiding section are provided at the inner-wall of the hollow room opposite to the shower plate. The second gas-ejection holes are for ejecting the gas into the hollow room, while the gas guiding section is for guiding the gas to the second gas-ejection holes from the gas introducing port.

The gas guiding section may include, for example, a channel formed in the inner-wall of the hollow room opposite to the shower plate and a cover that covers the channel. The gas guiding section is not necessarily be configured to include such a channel, but may be configured to include holes formed on the inner-wall of the hollow room, for example.

When the gas guiding section includes the channel formed in the inner-wall of the hollow room opposite to the shower plate and the cover that covers the channel, the gas guiding section can easily be formed in the inner-wall of the hollow room.

The channel may be, for example, linear, curved, or formed by a combination of a linear portion and a curved portion. The cover can be constituted from, for example, a flat plate having a planar shape same as a planar shape of the channel.

The second gas-ejection holes can be provided, for example, by opening through-holes in the cover. When the gas-ejection holes are provided by opening the through-holes in the cover, positions and diameters of the second gas-ejection holes can easily be changed (adjusted) by exchanging the cover.

The second gas-ejection holes can be provided, for example, on the portion where the channel is not covered by the cover. When the second gas-ejection holes are provided on the portion where the channel is not covered by the cover, the positions and the diameters of the second gas-ejection holes can easily be changed (adjusted) by exchanging the cover.

The second gas-ejection holes can be provided, for example, at a central part of the inner-wall of the hollow room opposite to the shower plate, and on a circumference of one circle or plural of circumferences of plural concentric circles about the central part. When the second gas-ejection holes are provided at such portions, a gas can more uniformly be supplied between the cathode electrode and the anode electrode, even when areas of the cathode electrode and the anode electrode are increased.

The second gas-ejection holes, for example, are provided in such a manner that at least one hole is provided at the central part of the inner-wall of the hollow room opposite to the shower plate and plural holes are provided on a circumference of one circle about the central part in a point symmetric manner. When the second gas-ejection holes are provided in such number and at such portions, a gas can be supplied more uniformly and reliably between the cathode electrode and the anode electrode, even when the areas of the cathode electrode and the anode electrode are increased.

It is preferable that an open area of the second gas-ejection hole provided on the central part of the inner-wall of the hollow room opposite to the shower plate is smaller than an open area of each of another second gas-ejection holes provided on one circumference of one circle or plural circumferences of plural concentric circles about the central part. When the open area of the second gas-ejection hole provided on the central part of the inner-wall of the hollow room opposite to the shower plate is smaller than the open area of each of another second gas-ejection holes provided on the circumference of one circle or plural circumferences of plural concentric circles about the central part, the gas at the central part of the cathode electrode is difficult to be exhausted when the areas of the cathode electrode and the anode electrode are increased, whereby the gas can more uniformly be supplied between the cathode electrode and the anode electrode.

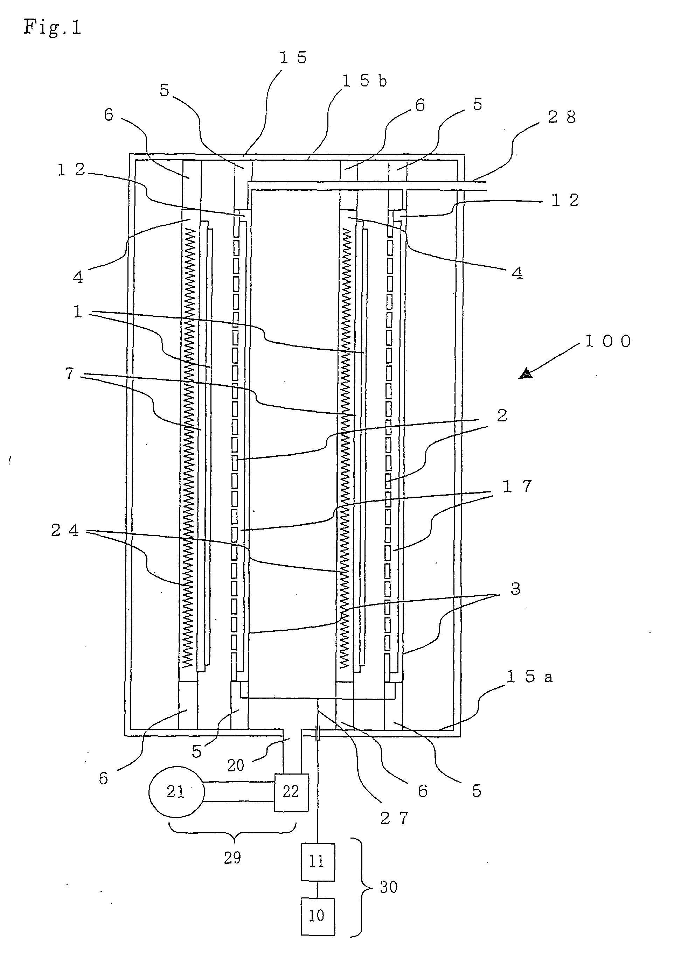

A plasma processing apparatus for forming a thin film according to one embodiment of the present invention will be described in detail with reference to Figs. 1 to 4.

As shown in Fig. 1, a thin-film forming plasma processing apparatus 100 has a chamber 15 serving as a reaction chamber for a plasma reaction, a gas introducing port 28 for introducing a reaction gas into the chamber 15, an exhaust section 29 for exhausting the reactive gas in the chamber 15, and a high-frequency power source section 30 for applying high-frequency power into the chamber 15.

Arranged in the chamber 15 are a rectangular flat-plate-like anode electrode 4, a rectangular flat-plate-like cathode electrode 12, two sets of a first support member 6 and a second support member 5 for supporting the respective electrodes 4 and 12 at respective peripheral regions thereof. The cathode electrode 12 has a shower plate 2 and a back plate 3, and is arranged so as to be opposite to the anode electrode 4.

The chamber 15 is made of a main body and a door (not shown) provided at the front of the main body. The main body and the door can be made of stainless steel, an aluminum alloy, or the like. A fitting section of the main body and the door is sealed by using an O-ring (not shown).

The exhaust section 29 including an exhaust pipe 20, a vacuum pump 21, and a pressure controller 22 is connected to the chamber 15 so as to be capable of controlling an inside of the chamber 15 to have an optional vacuum.

One first support member 6 is provided in proximity to each corner of a rectangular bottom surface 15a and a rectangular top surface 15b of the main body of the chamber 15, wherein the respective first support members 6 support the anode electrode 4.

The size of each of the anode electrodes 4 is set to a suitable size according to a size of a substrate 1 on which a film is to be formed. In the present embodiment, the size of the substrate 1 is set to be 900 × 550 mm, and a planar size of the anode electrode 4 according to the substrate 1 is set to be 1000 × 600 mm, and a thickness thereof is set to be 10 to 30 mm.

The anode electrode 4 can be made of stainless steel, an aluminum alloy, carbon, or the like. In the present embodiment, the anode electrode 4 is made of an aluminum alloy.

The anode electrode 4 has a hollow structure, wherein a heater (sheath heater) 24 is incorporated in a hollow portion thereof. The anode electrode 4 has a residual processing strain left therein due to a machining process, which is performed to create the hollow structure. Therefore, the anode electrode 4 is subjected to an annealing treatment to remove the residual processing strain, before it is used. The annealing treatment is performed by using a closed-type temperature sensor such as a thermocouple. A treatment temperature in the annealing treatment is different depending upon a metal used as the anode electrode 4. When an aluminum alloy is used, there is generally employed a temperature cycle in which the aluminum alloy is kept to be 345°C, and then, slowly cooled.

The anode electrode 4 is fixed to the first support member 6 with a screw.

The anode electrode 4 and the chamber 15 are electrically connected with two ground plates. Specifically, the ground plate is made of an aluminum plate having a width of 10 to 35 mm and a thickness of 0.5 to 3 mm, and is attached to each of upper and lower end faces of the anode electrode 4.

Each of the cathode electrodes 12 includes a rectangular flat-plate-like shower plate 2 and a back plate 3 that covers the shower plate 2 from back. A hollow room 17 is provided between the shower plate 2 and the back plate 3. The shower plate 2 and the back plate 3 can be made of stainless steel, an aluminum alloy, or the like, but it is preferable that they are made of a material substantially same as the material of the anode electrode 4. In the present embodiment, the shower plate 2 and the back plate 3 are made of an aluminum alloy.

A size of the cathode electrode 12 is set to a suitable size according to the size of the substrate 1 on which a film is to be formed. In the present embodiment, a planar size of the cathode electrode 12 is set to be 1000 × 600 mm, and a thickness is set to be 20 to 30 mm, which are substantially equal to the size of the anode electrode 4.

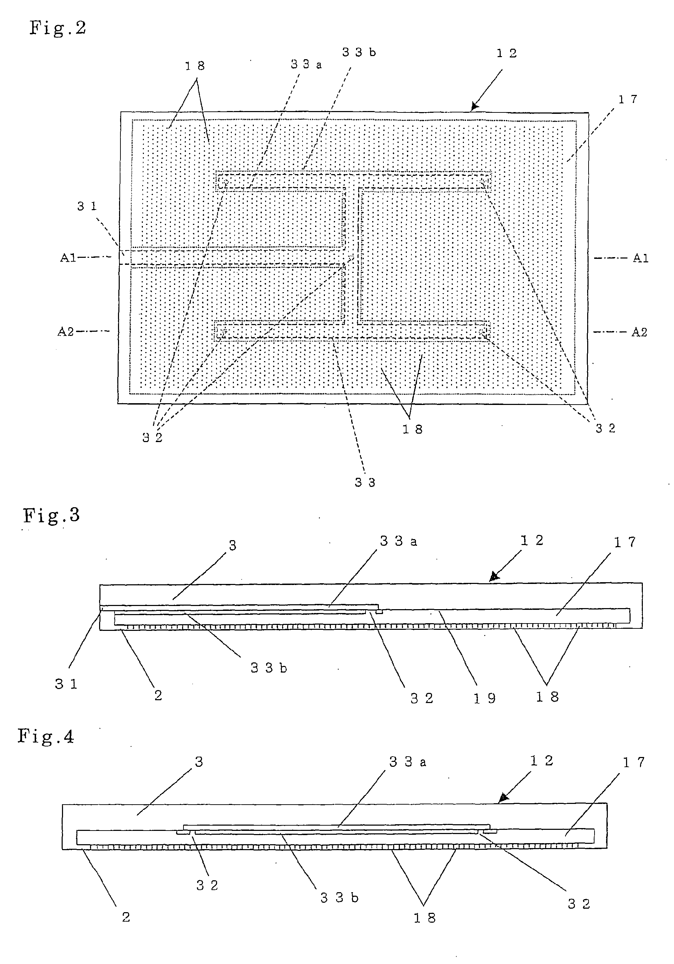

As shown in Figs. 2 to 4, the hollow room 17 occupies about 95% of the planar area of the cathode electrode 12, and a height thereof (e.g., 8 mm) occupies about 30% of the thickness of the cathode electrode 12 (e.g., 25 mm).

Plural (several hundreds) first gas-ejection holes 18 are provided on substantially an entire surface of the shower plate 2. Each of the gas-ejection holes 18 has a diameter of 0.1 mm, and are arranged in such a manner that an arrangement space (pitch) between the adjacent first gas-ejection holes 18 is 2.0 mm. These first gas-ejection holes 18 are for ejecting a gas, which is introduced into the hollow room 17, between the cathode electrode 12 and the anode electrode 4 from the hollow room 17.

As shown in Fig. 3, a lower surface of the back plate 3 of the cathode electrode 12 also serves as a ceiling surface of the hollow room 17, and it is sometimes referred to herein as a inner-wall 19 of the hollow room 17 opposite to the shower plate 2.

A gas introducing port 31 for introducing a gas from an outside of the cathode electrode 12 is provided at one of the electrode end face of the inner-wall 19 of the hollow room 17 opposite to the shower plate 2. Further, the inner-wall 19 of the hollow room 17 opposite to the shower plate 2 is provided with five second gas-ejection holes 32 for ejecting the gas into the hollow room 17 and a gas guide section 33 for guiding the gas to these second gas-ejection holes 32.

As shown in Fig. 2, the five second gas-ejection holes 32 are provided in such a manner that one second gas-ejection hole is provided at a center of the inner-wall 19 of the hollow room 17 opposite to the shower plate 2, and four second gas-ejection holes are provided on a circumference of one circle around the center in a point symmetric manner.

The gas guide section 33 includes a channel 33a formed on the inner-wall 19 of the hollow room 17 opposite to the shower plate 2 and a cover 33b that covers the channel 33a.

As shown in Fig. 2, the channel 33a has an H-shaped section that has an H-shaped planar shape and is formed on the central part of the inner-wall 19 of the hollow room 17, and an I-shaped section that has one end communicating with the gas introducing port 31 and the other end communicating with a central part of the H-shaped section. A length of the H-shaped section in a direction of a long side is set to be 600 mm, while a length of the I-shaped section in a direction of a long side is set to be 480 mm. The channel 33a has a rectangular cross section, and is set to have a width of 20 mm and a depth of 2 mm.

The cover 33b includes an H-shaped section and an I-shaped section corresponding to the above planar shape of the channel 33a. The cover 33b is made of a material same as that of the cathode electrode 12, and is set to have a width of 30 mm and a thickness of 1 mm. The cover 33b is fixed to an opening peripheral edge of the channel 33a of the inner-wall 19 of the hollow room 17 with a screw.

As shown in Figs. 2 to 4, in the five second gas-ejection holes 32, the one second gas-ejection hole 32, which is provided at the center of the inner-wall 19 of the hollow room 17, is open at the central part of the H-shaped section of the channel 33a, while the four second gas-ejection holes 32 provided on one circumference in a point symmetric manner are open at the respective four corners of the H-shaped section of the channel 33a.

A diameter of the one second gas-ejection hole 32 is 1.5 mm, and a diameter of each of the four second gas-ejection holes 32 is 2.0 mm. Accordingly, the open area of the one second gas-ejection hole 32 is set to be smaller than the respective open areas of the four second gas-ejection holes 32.

As shown in Figs. 2 and 3, the gas introducing port 31 of the cathode electrode 12 communicates with one end of the I-shaped section of the channel 33a. A reactive gas introduced from the gas introducing section 28 shown in Fig. 1 into the hollow room 17 through the gas introducing port 31 of the cathode electrode 12, the I-shaped section and the H-shaped section of the channel 33a, and the five second gas-ejection holes 32 is ejected like a shower between the cathode electrode 12 and the anode electrode 4 from several hundreds of first gas-ejection holes 18 formed on the shower plate 2 of the cathode electrode 12.

Similar to the anode electrode 4, a residual processing strain caused by a machining process is also left in the shower plate 2 and the back plate 3 of the cathode electrode 12. Therefore, before the cathode electrode 12 is used, an annealing treatment is performed to remove the residual processing strain. A treatment temperature in the annealing treatment is different depending upon a metal used as the shower plate 2 and the back plate 3. When an aluminum alloy is used, there is generally employed a temperature cycle in which the aluminum alloy is kept to be 345°C, and then, slowly cooled.

As shown in Fig. 1, two sets of the cathode electrodes 12 are supported on a total of eight second support members 5, which are provided on the rectangular bottom surface 15a and the rectangular top surface 15b of the main body of the chamber 15. Each of the second support members 5 can be made of glass, alumina, or zirconia, or the like, and in this embodiment, alumina or zirconia is used.

The respective cathode electrodes 12 are fixed on the second support members 5 with screws.

A high-frequency power source section 30 including a plasma exciting power source 10 and an impedance matching box 11 is connected to the respective cathode electrodes 12 through a power introducing terminal 27 so as to apply high-frequency power. The plasma exciting power source 10 uses power of 10 W to 100 kW with a frequency of DC to 108.48 MHz. In the present embodiment, power of 10 W to 100 kW with a frequency of 1 MHz to 54.24 MHz is used.

A reactive gas composed of SiH, which is diluted with H₂, is introduced into the thin-film forming plasma processing apparatus 100 having the above-mentioned configuration with a predetermined flow rate and a predetermined pressure through the cathode electrode 12, and the high-frequency power is applied between the cathode electrode 12 and the anode electrode 4 to produce a glow discharge. Accordingly, a silicon thin film with a thickness of 300 nm is deposited onto the substrate 1 for a film forming time of 10 minutes with a thickness distribution of less than and equal to ±10%.

Although the plasma processing apparatus 100 has a two-stage structure in the present embodiment, a structure of three or more stages is possible in another plasma processing apparatus by repeating similar structures.

## Claims

1. A plasma processing apparatus comprising: a reaction chamber for a plasma reaction; an exhaust section for exhausting a gas from the reaction chamber; and a flat-plate-like cathode electrode and a flat-plate-like anode electrode arranged in the reaction chamber so as to be opposite to each other, wherein
plural sets of the cathode electrode and the anode electrode are arranged in opposing directions thereof,
each of the cathode electrodes includes a hollow room therein, and a shower plate provided with plural first gas-ejection holes for ejecting the gas, which is introduced into the hollow room, from the hollow room to a portion between the cathode electrode and the anode electrode,
a gas introducing port for introducing the gas from an outside of the cathode electrode is provided at an electrode end face of an inner-wall of the hollow room opposite to the shower plate at the cathode electrode, and
plural second gas-ejection holes for ejecting the gas into the hollow room and a gas guiding section for guiding the gas from the gas introducing port to the second gas-ejection holes are provided at the inner-wall of the hollow room opposite to the shower plate.

2. The plasma processing apparatus according to claim 1, wherein
the gas guiding section includes a channel formed on the inner-wall of the hollow room opposite to the shower plate, and a cover that covers the channel.

3. The plasma processing apparatus according to claim 2, wherein
the cover is a flat plate.

4. The plasma processing apparatus according to claim 2 or 3, wherein
the second gas-ejection holes are provided by opening through-holes in the cover.

5. The plasma processing apparatus according to claim 2 or 3, wherein
the second gas-ejection holes are provided on a portion where the channel is not covered by the cover.

6. The plasma processing apparatus according to any one of claims 1 to 5, wherein
the second gas-ejection holes are provided on a central part of the inner-wall of the hollow room opposite to the shower plate and on a circumference of one circle or plural circumferences of plural concentric circles about the central part.

7. The plasma processing apparatus according to any one of claims 1 to 6, wherein
the second gas-ejection holes are provided in such a manner that at least one hole is provided at the central part of the inner-wall of the hollow room opposite to the shower plate and plural holes are provided on the circumference of one circle about the central part in a point symmetric manner.

8. The plasma processing apparatus according to claim 6 or 7, wherein
an open area of each of the second gas-ejection holes provided on the central part of the inner-wall of the hollow room opposite to the shower plate is smaller than an open area of each of another second gas-ejection holes provided on one circumference of one circle or plural circumferences of plural concentric circles about the central part.
